Europäisches Patentamt

**European Patent Office**

**Office européen des brevets**

(19)

(11) Publication number : **0 480 581 A1**

(12) **EUROPEAN PATENT APPLICATION**

(21) Application number : **91308222.8**

(22) Date of filing : **09.09.91**

(51) Int. Cl.⁵ : **C23C 16/44**

(30) Priority : **10.09.90 US 579851**

(43) Date of publication of application :
**15.04.92 Bulletin 92/16**

(84) Designated Contracting States :
**CH DE FR GB IT LI NL SE**

(71) Applicant : **APPLIED SCIENCE & TECHNOLOGY, INC.**
**35 Cabot Road**
**Woburn, Massachusetts 01801 (US)**

(72) Inventor : **Smith, Donald K.**
**167 Waverly Street**
**Arlington, Massachusetts 02174 (US)**

(74) Representative : **Jones, Graham H.**
**Graham Jones & Company 77 Beaconsfield Road Blackheath**
**London SE3 7LG (GB)**

(54) **Recirculating high velocity convective flow reactor system.**

(57) A recirculating high velocity convective flow reactive system (10) including a reactor (12) into which gas is introduced, a gas activation region (22) in the reactor (12) along with a device (20) for supplying energy to the gas in that region (22) to activate the gas, an activated gas surface interaction region in the reactor (12) spaced from the activation region (22) for utilizing the activate gas, and a high velocity pump (18) for moving the activated gas from the activation region (22) to the interaction region by convection while it remains active.

*Fig. 2A*

EP 0 480 581 A1

## FIELD OF INVENTION

This invention relates to a recirculating high velocity convective flow reactor system which is particularly suited for chemical vapor deposition of large areas of diamond particles or films.

## BACKGROUND OF INVENTION

Many chemical vapor deposition (CVD) and etching processes involve the activation of a gas or a gas mixture and transport of the activated gas to a substrate where it either reacts and condenses to form a film of material or reacts to etch the substrate material. The gas may be activated by a number of means such as a hot filament, a microwave discharge, a DC discharge, plasma jets and torches. In each of these processes, energy is transferred to the gas to create a gas containing ions, atoms, radicals, molecules, and/or electrons, many of which species may be in excited states. Such gas may be termed an activated gas.

The different species of the activated gas have different useful lifetimes depending on the species and the intended use. After the gas is activated, various chemical reactions and relaxation of excited states will occur, destroying the activated gas. This depletion and deactivation places severe constraints on the distance which can separate the activation region from the deposition or etching region where the activated gas is used.

There are varying approaches to the problem of employing the activated gas while it remains in the useful state. Typically, those processes may be divided into high pressure processes that operate at or near atmospheric pressure, and low pressure processes that operate typically from sub-torr pressures to tens to hundreds of torr.

The high pressure processes include plasma jet and torch reactor systems in which an atmospheric pressure flowing gas stream is ignited with either an electric arc or microwave discharge to create a plasma, or a flame to create a torch. In such systems, the jet or flame is typically relatively small due to the volume of gas and energy required to sustain the torch at atmospheric pressure. These jets or flames typically have areas of approximately twenty-five square millimeters or less. As a result, they are suited only for small area deposition.

In diamond film growth, a mixture of hydrogen and a carbon-containing compound such as methane is typically employed, sometimes with a third gas such as oxygen, which mixture is activated and supplied to a silicon substrate. Often, the hydrogen makes up 90% to 99% of the total gas volume. In the atmospheric pressure plasma jet and torch reactor systems, the gas flow rates must be on the order of liters per minute to sustain the flame. As a result, these atmospheric pressure deposition systems are extremely costly to operate, especially in light of their return of only small area films.

The lower pressure CVD reactor systems employing a hot filament, microwave discharge, or electric discharge to activate the gas typically operate at approximately 100 torr or less to create an activated gas volume of no more than one to two inches in diameter. The active species created in the region typically have a lifetime on the order of tens of milliseconds. At such conditions, the active species diffuse only one or two centimeters during that short lifetime. Accordingly, in such systems the substrate must be placed adjacent to or within the activation region in order to deposit the species of interest. This constraint severely limits the size of the deposited films to approximately the same size as the activated gas. Accordingly, such systems are not able to deposit large area films. In such systems, the gas flow velocity is negligible - gas motion is due almost exclusively to diffusion.

One such CVD system is disclosed in U.S. Patent No. 3,108,900, issued to C. A. Papp. The Papp system operates in the range of one to thirty torr, and employs a glow discharge to energize the gas to create species to be deposited. The Papp system employs a mercury diffusion pump for circulation, the process gas from the deposition region to the activation region so that the species to be deposited on the substrate are moved from the activation region to the deposition region by low velocity gas flow and diffusion instead of the usual attraction of the gas atoms to the target by electrostatic attraction. Thus, the Papp arrangement resulted in a reduction in the energy requirements for a given coating.

The Papp system also employs a mercury diffusion pump, with a downstream liquid nitrogen mercury trap for removing the mercury vapor from the recirculation stream to prevent mercury from depositing on the substrate. Since such liquid nitrogen mercury traps operate only at low gas velocities, typically in the diffusion regime, the actual flow velocity in the Papp system was likely on the order of no more than a few centimeters per second. This conclusion is bolstered by the fact that the mercury diffusion pump employed in the Papp system, at the operating pressure of approximately ten torr, would be capable of moving gas through the system at only centimeters per second.

## SUMMARY OF INVENTION

It is therefore an object of this invention to provide a recirculating high velocity convective flow reactor system which can deposit over an extremely large area.

It is a further object of this invention to provide such a system which is well suited to deposit large area diamond films.

It is a further object of this invention to provide such a system in which the deposition or surface interaction region can be spaced from the gas activation region even if the activated species have an extremely short lifetime.

It is a further object of this invention to provide such a system which can use a number of different energy sources to activate the gas.

This invention results from the realization that in order to deposit short-lived species over a large area at relatively low pressure, the species must be moved from the region where they are activated to the region where they are deposited in a high velocity gas stream operating well into the convection regime.

This invention features a recirculating high velocity convective flow reactor system including a reactor, means for introducing gas into the reactor, a gas activation region in the reactor, means for activating the gas in the gas activation region, and an activated gas surface interaction region in the reactor spaced from the activation region for utilizing the activated gas. Further included is a high velocity pump for moving the activated gas from the activation region to the interaction region by convection while it remains active.

The gas may be activated by supplying microwave energy to the activation region, with a heated filament, or with an electric arc, a laser or an rf discharge. Preferably, the pump is downstream of the interaction region for recirculating the gas from that region back to the activation region. The system also preferably includes means for exhausting gas from the reactor, which may be accomplished with a vacuum pump. Further included may be means for maintaining a desired pressure in the reactor, which may be accomplished with a throttle valve. Preferably, the pressure is below atmospheric, and may be in the range of approximately ten to approximately one hundred torr. The system preferably also includes means for holding a substrate in a surface interaction region, along with means for heating the substrate.

In a preferred embodiment, the system is accomplished in a flow through reactor large area diamond deposition system in which a carbon containing gas is introduced into a CVD reactor and activated with microwave energy in an activation region. The gas is then moved from the activation region to a downstream deposition region by a high velocity pump to supply the active species to the substrate in their lifetime to accomplish large area deposition of a diamond film.

## DISCLOSURE OF PREFERRED EMBODIMENT

Other objects, features and advantages will occur to those skilled in the art from the following description of a preferred embodiment and the accompanying drawings, in which:

Fig. 1 is a schematic diagram of a recirculating high velocity convected flow reactor system according to this invention;

Fig. 2A is an embodiment of the system of Fig. 1 employing microwave energy to activate the gas;

Fig. 2B discloses an alternative hot filament gas energizer for the system of Fig. 1;

Fig. 2C discloses an alternative electric arc gas energizer for the system of Fig. 1; and

Figs. 2D and 2E show additional rf and laser gas energizing means for the system of Fig. 1.

This invention may be accomplished in a recirculating high velocity convective flow reactor system in which a high velocity pump is used to recirculate the gas from the surface interaction region to the gas activation region to swiftly move the activated gas from the activation region to the interaction region by convection while it remains active. This arrangement allows the surface interaction region to be spaced well downstream of the gas activation region, as well as providing the ability of greatly expanding the activated gas to effect a large area deposition.

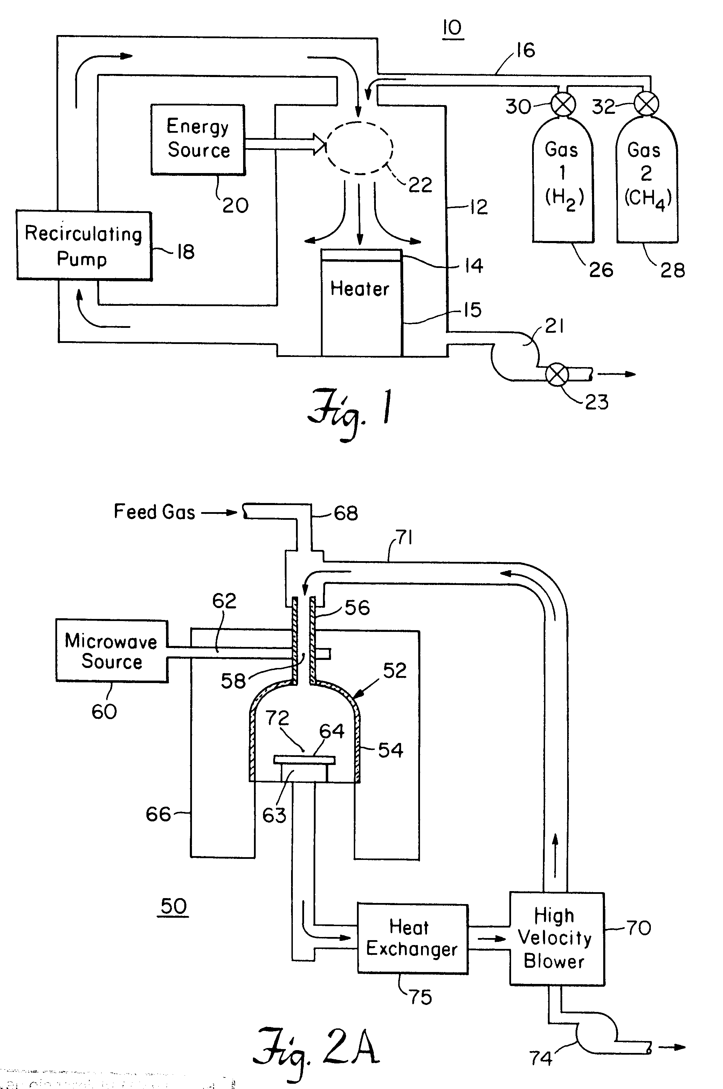

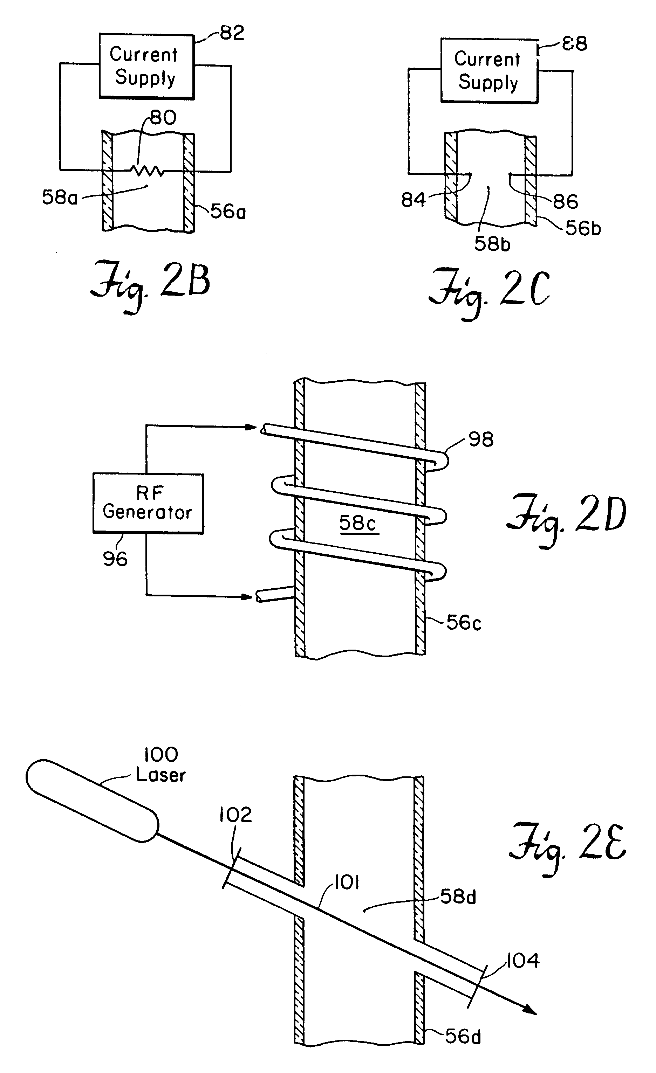

There is shown in Fig. 1 recirculating high velocity convective flow reactor system 10 according to this invention including reactor 12 with gas activation region 22 and substrate 14 held in a gas surface interaction (deposition or etching) region by heater 15. The gas to be activated enters the system through line 16 from sources 26 and 28 controlled by valves 30 and 32, respectively. In this example, source 26 is hydrogen gas and source 28 is methane gas, for depositing a diamond film on silicon substrate 14. The feed gas could alternatively enter the system at any location. Vacuum pump 21 with throttle valve 23 is employed in conjunction with the gas feed system to maintain the system pressure at a desired level, typically from ten to one hundred torr, although the system may operate at virtually any sub-atmospheric pressure, down to millitorr.

Energy source 20 supplies energy to the gas in activation region 22 to create the desired active species, which are swiftly moved from activation region 22 to substrate 14 during the lifetime of the activated gas species by high velocity recirculating pump 18. Pump 18 may be a model 1000L Turbostream pump manufactured by Leybold-Heraeus GmbH of West Germany.

A microwave plasma chemical vapor deposition system according to this invention is schematically depicted in Fig. 2A. System 50 includes reactor vessel 52, which includes quartz deposition chamber 54 having substrate 64 therein on support 63 proximate deposition region 72, along with quartz tube 56 having activation region 58 therein. Microwave source 60 supplies the gas activation energy to region 58 through waveguide 62. Furnace 66 surrounds reaction chamber 52 to maintain the chamber and substrate at a desired temperature, which may be approximately 1000°C. The feed gas to be energized enters the system through port 68, where it is entrained in the high velocity gas flow from blower 70, reentering the reactor through line 71. Blower 70 may operate at approximately 1,000 cubic meters per hour to create a gas velocity within reactor 50 in the range of 1,000 to 20,000 centimeters per second. Heat exchanger 75 may be placed upstream of blower 70 for cooling the gas to the blower operating temperature.

Using a feed gas mixture containing hydrogen, methane, and carbon dioxide introduced into the system at a rate of 500 standard cubic centimeters per minute, operating at a pressure of ten to one hundred torr, a system similar to that depicted in Fig. 2A using a four inch hot plate instead of furnace 66 to heat the substrate 50 was able to deposit a diamond film across a four inch diameter substrate spaced approximately eighteen inches from the gas activation region, which was itself in a one inch diameter quartz tube. At these operating conditions, the Peclet number was of the order of one hundred, indicating that the gas flow was strongly within the convection regime, as compared with the typical Peclet numbers of the order of $1 \times 10^{-2}$ for the typical microwave plasma deposition systems such as that disclosed in U.S. Patent No. 4,866,346. Vacuum pump 74 is employed to maintain a proper mass flow through system 50 and to maintain the pressure in reactor 52 at the proper operating point.

Figs. 2B-2E depict gas activation alternatives to the microwave source of Fig. 2A. Hot resistive filament 80, Fig. 2B, is placed within the gas flow in activation region 58a within reactor tube 56a and is heated by current supply 82 to energize the gas into the activated state. Alternatively, current supply 88, Fig. 2C, can be employed to supply energy to the gas in activation region 58b within tube 56b by passing an arc or discharge between electrodes 84 and 86. Gas activation may alternatively be accomplished with rf energy employing rf generator 96 and induction coil 98, Fig. 2D, surrounding flow tube 56C for energizing gas in region 58C. Laser 100, Fig. 2E, may energize gas in region 58d by passing beam 101 through laser-transparent windows 102 and 104 for maintaining the integrity of flow tube 56d.

In the reactor system of this invention, the activated gas flow from the activation region to the surface interaction region is characterized by being strongly convective. That is, the Peclet number is much greater than one. The Peclet number, P, is a dimensionless number equal to the flow velocity times the relevant scale length divided by the gas diffusion coefficient. The diffusion regime is defined by a Peclet number less than one, and the convection regime by a Peclet number greater than one. In the typical CVD systems operating at relatively low pressures of under one hundred torr, the diffusion coefficient is high (perhaps 250 square centimeters per second), and the velocity low, yielding a Peclet number much less than one, indicative of a flow predominated by diffusion. Since the active species are short lived (likely of the order often to one hundred milliseconds), the useful range of the activated gas in such systems is only centimeters. In other words, the substrate to be acted upon must be within centimeters of the activated gas. Thus, the substrate must be placed virtually within the activation region and also may not be much larger than an activation region, typically less than an inch in diameter. Accordingly, those systems are only able to deposit small films.

By adding a diffusion recirculation pump to a CVD system, as done by Papp, the activated gas is urged toward the substrate to some extent by the diffusion pump flow. However, at the Papp operating pressures of up to approximately ten torr, due to the amount of mass which must be moved by the relatively weak diffusion pump, the gas moves at velocities of only a few centimeters per second. Also, the Papp nitrogen trap will not work to remove mercury vapor at higher velocities. Accordingly, the Peclet number in the Papp system will be less than one, indicating that the flow is primarily diffusive, with only gentle gas flow created by the diffusion pump. In the Papp system, the mean free path of the reactants needs to be large, requiring low pressures of 0.5 to 1.0 torr for hydrogen. For deposition chamber larger than 30 millimeters, the Papp system requires even lower pressures, indicating Peclet numbers much less than one.

In the system of the present invention, transport is effected by convection. In the convection regime, the activated gas species are swept along the flow lines, as indicated in Fig. 1, by motion of the gas rather than by diffusion. This transports the species to the substrate within their millisecond lifetime to allow the activated species to deposit on the substrate. Since the active species depletion range in the convection regime is linear with gas velocity, at system velocities of ten meters per second or more, active species from a typical activation region of perhaps one inch in diameter can be moved up to forty inches or more during their estimated ten to one hundred millisecond lifetime. Accordingly, the substrate to be acted upon can be spaced from the activation region, and the activated gas can be delivered to a large area substrate.

Although specific features of the invention are shown in some drawings and not others, this is for convenience only as each feature may be combined with any or all of the other features in accordance hgith the invention.

Other embodiments will occur to those skilled in the art and are within the following claims.

## Claims

1. A recirculating high velocity convective flow reactor system, comprising:
   a reactor;
   means for introducing gas into said reactor;
   a gas activation region in said reactor;
   means for activating the gas in said activation region;
   an activated gas surface interaction region in said reactor spaced from said activation region for utilizing the activated gas; and
   a high velocity pump for moving the activated gas from said activation region to said interaction region by convection while it remains active.

2. The reactor system of claim 1 in which said means for activating includes means for supplying microwave energy to said activation region.

3. The reactor system of claim 1 in which said means for activating includes a heated filament in said activation region.

4. The reactor system of claim 1 in which said means for activating includes means for supplying an electric arc to said activation region.

5. The reactor system of claim 1 in which said pump is downstream of said surface interaction region for recirculating gas from said surface interaction region back to said activation region.

6. The reactor system of claim 1 further including means for exhausting gas from said reactor.

7. The reactor system of claim 6 in which said means for exhausting includes a vacuum pump.

8. The reactor system of claim 6 further including means for maintaining a desired pressure in said reactor.

9. The reactor system of claim 8 in which said means for maintaining includes a throttle valve.

10. The reactor system of claim 8 in which the pressure is below atmospheric.

11. The reactor system of claim 10 in which the pressure is in the range of approximately 10 to approximately 100 torr.

12. The reactor system of claim 1 further including means for holding a substrate in said surface interaction region.

13. The reactor system of claim 12 further including means for heating said substrate.

14. A recirculating high velocity convective flow chemical vapor deposition system, comprising:
    a reactor;
    means for introducing gas into said reactor;
    means for supplying microwave energy to an activation region of said reactor for activating the gas;
    means for holding a substrate in said reactor in a deposition region spaced from said activation region;
    means for maintaining a below-atmospheric pressure in said reactor; and
    means for withdrawing gas from said deposition region and recirculating it back to said activation region at high velocity to move the activated gas from said activation region to said deposition region by convection while it remains active for depositing activated gas species on the substrate.

15. A flow-through reactor large area diamond deposition system, comprising:
    a chemical vapor deposition reactor having a gas activation region, and an activated gas deposition region spaced from and downstream of said activation region;
    means for introducing a carbon-containing gas to be activated into said reactor;
    means for coupling microwave energy to said activation region to energize and activate the gas;
    a substrate holder in said deposition region for holding a substrate upon which the activated gas is to be deposited;
    a vacuum pump for withdrawing gas from said reactor to maintain said reactor at a below-atmospheric pressure; and
    a high-velocity pump for withdrawing gas from said deposition region and pumping it back into said reactor upstream of said activation region to force the gas through said activation region down to said substrate while the gas remains active for depositing the active gas on said substrate to form a diamond film thereon.

*Fig. 1*

*Fig. 2A*

*Fig. 2B*

*Fig. 2C*

*Fig. 2D*

*Fig. 2E*

**European Patent Office**

## EUROPEAN SEARCH REPORT

Application Number

EP 91 30 8222

### DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | WO-A-8 503 460 (J.J. SCHMITT) * Page 5, lines 6-12; page 14, lines 4-25; page 23, line 26 - page 24, line 14; page 50, lines 6-20; example 1; claims 1,3,7 * | 1-9,12-13 | C 23 C  16/44 |
| Y | --- | 10-11 | |
| Y,D | US-A-3 108 900 (C.A. PAPP) * Column 2, lines 43-51 * ----- | 10-11 | |
| | | | **TECHNICAL FIELDS SEARCHED (Int. Cl.5)** |
| | | | C 23 C |

The present search report has been drawn up for all claims

| Place of search | Date of completion of the search | Examiner |
|---|---|---|
| THE HAGUE | 16-12-1991 | EKHULT H.U. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)